# DEMANDE DE BREVET EUROPEEN

(11) **EP 1 197 991 A1**
(43) Date de publication de la demande: **17.04.2002**
(21) Numéro de dépôt: 01410128.1
(22) Date de dépôt: 11.10.2001
(51) Int. Cl.: H01L 21/02

(54) **Procédé de fabrication d'une structure monolithique comportant un condensateur à diélectrique pérovskite**

(30) Priorité: 13.10.2000 FR 0013178
(71) Demandeur: STMicroelectronics S.A., 92120 Montrouge (FR)
(72) Inventeur: Charpentier, Pascale, 44470 Carquefou (FR); Anceau, Christine, 37390 Saint Roch (FR)
(74) Mandataire: de Beaumont, Michel

(57) **Abrégé**

La présente invention concerne un procédé de fabrication, sur un substrat de silicium, d'un condensateur de forte capacité, comprenant les étapes successives suivantes :
revêtir le substrat d'une première couche isolante (6),
former et graver successivement sur le substrat :
   - une première électrode (10),
   - un diélectrique en un matériau ferroélectrique à forte constante diélectrique (11), et
   - une deuxième électrode (12),
revêtir la structure d'une deuxième couche isolante (14) d'encapsulation de la structure de condensateur,
réaliser des ouvertures de contact vers des zones semiconductrices et vers la première électrode du condensateur,
déposer et graver une première couche conductrice (21-25),
déposer une troisième couche isolante de protection (30),
déposer une deuxième couche conductrice (31) établissant en particulier un contact avec l'électrode supérieure du composant,
déposer une couche de passivation finale (33).

## Description

La présente invention concerne des composants électroniques sous forme de structures monolithiques incorporant des composants actifs formés dans un substrat semiconducteur et des composants passifs formés au-dessus de ce substrat, parmi lesquels se trouvent des condensateurs.

La réalisation de condensateurs dans des structures monolithiques se heurte à des problèmes d'encombrement. En effet, la capacité d'un condensateur est définie par sa surface, l'épaisseur de son diélectrique et la constante diélectrique du matériau utilisé. Les matériaux couramment utilisés comme diélectriques ont des constantes diélectriques inférieures à 10, par exemple 3,9 pour l'oxyde de silicium et 7 pour le nitrure de silicium, ce qui permet d'obtenir des condensateurs dont la capacité par unité de surface est de l'ordre de 1 à 2 nF/mm².

Si l'on veut obtenir des condensateurs de plus forte capacité par unité de surface, par exemple de 20 à 30 nF/mm², il faut utiliser comme diélectrique des matériaux à forte constante diélectrique tels que des pérovskites qui comprennent par exemple le zirconate titanate de plomb (Pb(ZrₓTi₁₋ₓ)O₃, avec x variant de (0 à 1, ou PZT), le titanate de baryum et de strontium (BaSrTiO₃ ou BST), le titanate de strontium et de baryum (SrBa₂TiO₉ ou SBT). Ces matériaux en couches minces ont des constantes diélectriques nettement supérieures à 100, qui peuvent atteindre des valeurs de l'ordre de mille pour le PZT. Toutefois, les propriétés de ces produits les rendent extrêmement difficiles à utiliser dans le cadre des processus industriels généralement utilisés dans le domaine de la fabrication des composants électroniques. Par exemple, le PZT est attaqué très rapidement dans les bains de nettoyage classiques (H₂SO₄/H₂O₂) et des composés à base de plomb peuvent contaminer une ligne de fabrication. En conséquence, on renonce généralement, notamment dans le cadre des composants de puissance, à réaliser des structures monolithiques incluant des condensateurs de forte capacité et l'on continue à utiliser des condensateurs discrets.

L'objet de la présente invention est de prévoir un procédé de fabrication permettant, de façon industrielle, de créer des structures monolithiques comprenant des composants actifs formés dans un substrat semiconducteur et divers composants passifs sur ce substrat dont au moins un condensateur à forte capacité par unité de surface, dans lequel le diélectrique est une pérovskite.

Un objet plus particulier de la présente invention est de prévoir un tel procédé compatible avec les étapes usuelles de fabrication de circuits monolithiques.

Pour atteindre cet objet, la présente invention prévoit un procédé de fabrication d'une structure monolithique comprenant, sur un substrat de silicium, des composants passifs dont un condensateur de forte capacité, comprenant les étapes successives suivantes :
revêtir le substrat d'une première couche isolante,
former et graver successivement sur le substrat :
   - une première électrode,
   - un diélectrique en un matériau ferroélectrique à forte constante diélectrique, et
   - une deuxième électrode,
revêtir la structure d'une deuxième couche isolante d'encapsulation de la structure de condensateur,
réaliser des ouvertures de contact vers des zones semiconductrices et vers la première électrode du condensateur,
déposer et graver une première couche conductrice,
déposer une troisième couche isolante de protection,
déposer une deuxième couche conductrice établissant en particulier un contact avec l'électrode supérieure du composant,
déposer une couche de passivation finale.

Selon un mode de réalisation de la présente invention, le diélectrique en matériau ferroélectrique est une pérovskite.

Selon un mode de réalisation de la présente invention, la pérovskite est du PZT.

Selon un mode de réalisation de la présente invention, le procédé comprend, après l'étape de dépôt de la première couche conductrice, une étape de dépôt d'une couche résistive et de gravure de cette couche pour former des résistances entre des plots de la première couche conductrice.

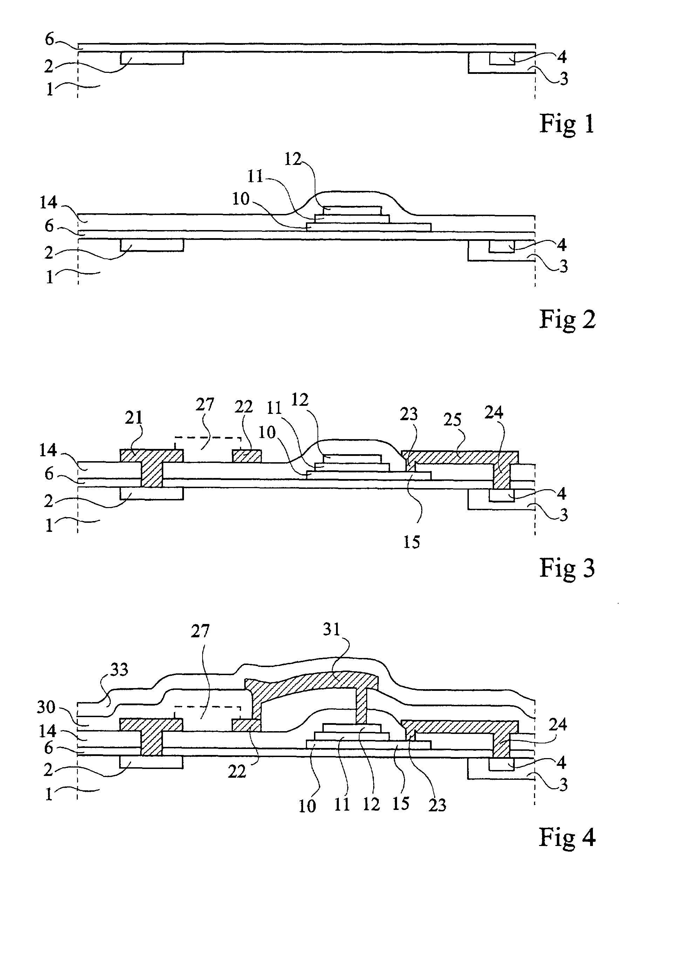

Ces objets, caractéristiques et avantages, ainsi que d'autres de la présente invention seront exposés en détail dans la description suivante de modes de réalisation particuliers faite à titre non-limitatif en relation avec les figures 1 à 4 ci-jointes qui décrivent des étapes successives de fabrication d'une structure selon un mode de réalisation de l'invention.

Une structure monolithique selon la présente invention est formée sur un substrat semiconducteur 1, couramment du silicium, comprenant éventuellement une couche supérieure épitaxiée. Dans ce substrat sont formées diverses régions de dopages distincts destinées à former des composants actifs tels que diodes, transistors bipolaires, transistors à effet de champ, ou des composants passifs tels que des résistances diffusées. Les composants actifs pourront correspondre à des structures latérales dont toutes les électrodes se retrouvent sur la face supérieure du substrat ou à des structures verticales dans lesquelles la face arrière du substrat est métallisée et correspond à une électrode active d'un ou plusieurs des composants formés dans le substrat. A titre d'exemple, on a représenté dans le substrat une région 2 de type de conductivité opposé à celui du substrat, correspondant par exemple à une électrode d'une diode, et des régions emboîtées 3 et 4, la région 3 correspondant par exemple à la base d'un transistor et la région 4 à son émetteur. Ces structures ne sont décrites ici qu'à titre d'exemple. De façon générale, la présente invention s'applique à un substrat dans lequel on a formé des régions et zones propres à constituer des éléments de composants actifs ou passifs.

La structure résultante est recouverte d'une couche isolante de protection 6, couramment en oxyde de silicium. Cette couche résulte du procédé de fabrication des composants dans le silicium ; elle est d'épaisseur variable, par exemple de 0,2 à 2 µm ; on peut augmenter son épaisseur en rajoutant un oxyde déposé. Sur cette couche de protection, selon l'invention, on forme d'abord un condensateur en déposant et en gravant successivement une première couche conductrice 10, un isolant 11 à forte constante diélectrique et une deuxième couche conductrice 12. La première couche conductrice 10 constituant la première électrode ou électrode inférieure du condensateur est de préférence métallique, en un métal propre à supporter un recuit à l'air à 700°C nécessaire à la formation de la pérovskite 11. Cette couche 10 pourra par exemple être constituée d'un bicouche titane-platine. La couche isolante 11 est une pérovskite, de préférence du PZT. La deuxième couche conductrice 12 constituant la deuxième électrode ou électrode supérieure du condensateur est de préférence métallique, par exemple en aluminium, platine ou or. Chacune des couches est gravée après son dépôt pour lui conférer la forme souhaitée.

Selon un aspect de la présente invention, une fois formées les trois couches constituant les deux électrodes et le diélectrique du condensateur, l'ensemble de la structure est revêtu d'une couche isolante d'encapsulation 14 destinée à éviter que, lors des opérations suivantes, la pérovskite soit susceptible d'être attaquée, de se dégrader, et de polluer d'autres zones de la structure, par exemple par du plomb dans le cas de PZT. Le fait d'encapsuler le PZT par la couche 14 permet selon un avantage important de la présente invention de conserver pour la formation des autres éléments de la structure des procédés classiques de masquage et de gravure, en utilisant notamment des gravures humides comme cela est usuel dans le cadre de la fabrication des composants de puissance.

Ensuite, comme cela est représenté en figure 3, la partie active de la structure de condensateur 10, 11, 12 étant maintenue encapsulée dans la couche de protection 14, on procède à des ouvertures et au dépôt d'une première métallisation.

Par exemple, on réalise une ouverture de contact au-dessus de la région semiconductrice 2, une ouverture de contact au-dessus de la région semiconductrice 4 et une ouverture de contact au-dessus d'une extension 15 de l'électrode inférieure 10 du condensateur.

On procède ensuite à une métallisation, par exemple pour constituer un plot de contact 21 avec la région semiconductrice 2, un plot 22, un plot de contact 23 avec l'électrode inférieure 15, et un plot de contact 24 avec la région semiconductrice 4. Cette métallisation est par exemple de l'aluminium. Dans l'exemple représenté, on a indiqué une liaison 25 entre les plots 23 et 24. Eventuellement, après cette étape, on peut déposer un matériau propre à constituer une résistance entre les plots 21 et 22. Ce matériau sera par exemple du nitrure de tantale, le dépôt de nitrure de tantale étant suivi d'une étape de gravure et pendant cette étape, la structure de condensateur est toujours encapsulée. Etant donné qu'il s'agit là d'une option, la région de nitrure de tantale 27 a été représentée en pointillés en figure 4.

Ensuite, on dépose sur la structure une nouvelle couche isolante de protection 30 dans laquelle on réalise des ouvertures de prise de contact avec divers éléments sous-jacents et notamment avec l'électrode supérieure 12 du condensateur. On procède alors au dépôt d'une deuxième métallisation 31 (par exemple de l'aluminium), qui, dans l'exemple représenté, établit une liaison entre le plot 22 et l'électrode supérieure 12. Enfin, à une étape finale, on pourra déposer une couche de passivation 33 (par exemple du PSG) sur la surface supérieure de la structure. Cette couche pourra être ouverte au-dessus de plots métalliques aux endroits où l'on veut établir des connexions vers l'extérieur, par exemple en soudant un fil ou en déposant une métallisation compatible avec des billes de soudure.

Ainsi, selon un avantage de la présente invention, la couche de pércvskite 11 ainsi que la couche conductrice 12 qui la recouvre partiellement est encapsulée par la couche isolante 14 pendant tout le processus et seule une partie supérieure de l'électrode supérieure 12 est découverte au moment où l'on veut établir la métallisation finale 31 de reprise de contact.

La présente invention est susceptible de diverses variantes et modifications qui apparaîtront à l'homme de l'art, notamment en ce qui concerne les matériaux isolants et de protection. On pourra par exemple, au lieu ou en plus de l'oxyde de silicium, utiliser du nitrure de silicium, une céramique isolante ou un matériau organique.

De même, les métaux destinés à établir les contacts pourront être choisis parmi divers métaux habituellement utilisés dans le domaine, par exemple de l'aluminium.

A titre d'autre variante de la présente invention, la première électrode 10 du condensateur, au lieu d'être déposée sur la couche isolante 6, peut être en contact direct avec une zone choisie du substrat 1 pour établir directement un contact avec cette zone. Dans ce cas, la couche 10 débordera de tout côté par rapport à ladite ouverture de façon que, lors du dépôt et de la gravure de la couche de PZT 11, on ne trouve pas de portion de substrat découverte.

## Revendications

1. Procédé de fabrication d'une structure monolithique comprenant, sur un substrat de silicium, des composants passifs dont un condensateur de forte capacité, comprenant les étapes successives suivantes :
revêtir le substrat d'une première couche isolante (6),
former et graver successivement sur le substrat :
- une première électrode (10),
- un diélectrique en un matériau ferroélectrique à forte constante diélectrique (11), et
- une deuxième électrode (12),
revêtir la structure d'une deuxième couche isolante (14) d'encapsulation de la structure de condensateur,
réaliser des ouvertures de contact vers des zones semiconductrices et vers la première électrode du condensateur,
déposer et graver une première couche conductrice (21-25),
déposer une troisième couche isolante de protection (30),
déposer une deuxième couche conductrice (31) établissant en particulier un contact avec l'électrode supérieure du composant,
déposer une couche de passivation finale (33).

2. Procédé selon la revendication 1, **caractérisé en ce que** le diélectrique en matériau ferroélectrique est une pérovskite.

3. Procédé selon la revendication 2, **caractérisé en ce que** la pérovskite est du PZT.

4. Procédé selon la revendication 1, **caractérisé en ce qu'**il comprend, après l'étape de dépôt de la première couche conductrice, une étape de dépôt d'une couche résistive (27) et de gravure de cette couche pour former des résistances entre des plots de la première couche conductrice.
